# EUROPÄISCHE PATENTSCHRIFT

(11) **EP 1 334 416 B1**
(45) Veröffentlichungstag und Bekanntmachung des Hinweises auf die Patenterteilung: **20.04.2005**
(21) Anmeldenummer: 01967051.2
(22) Anmeldetag: 30.08.2001
(51) Int. Cl.: G06F 1/00

(54) **SCHALTUNGSANORDNUNG UND VERFAHREN ZUM DETEKTIEREN EINES UNERWÜNSCHTEN ANGRIFFS AUF EINE INTEGRIERTE SCHALTUNG**
CIRCUIT ARRANGEMENT AND A METHOD FOR DETECTING AN UNDESIRED ATTACK ON AN INTEGRATED CIRCUIT
CIRCUITERIE ET PROCEDE POUR LA DETECTION D'UNE ATTAQUE INDESIRABLE CONTRE UN CIRCUIT INTEGRE

(30) Priorität: 11.09.2000 DE 10044837
(43) Veröffentlichungstag der Anmeldung: 13.08.2003
(73) Patentinhaber: Infineon Technologies AG, 81669 München (DE)
(72) Erfinder: GAMMEL, Berndt, 85570 Markt Schwaben (DE)
(74) Vertreter: Epping Hermann & Fischer
(86) Internationale Anmeldenummer: PCT/DE2001/003335
(87) Internationale Veröffentlichungsnummer: WO 2002/021241

(56) Entgegenhaltungen:
- WO-A-99/04334
- MARTIN A J ET AL: "The design of an asynchronous MIPS R3000 microprocessor" ADVANCED RESEARCH IN VLSI, 1997. PROCEEDINGS., SEVENTEENTH CONFERENCE ON ANN ARBOR, MI, USA 15-16 SEPT. 1997, LOS ALAMITOS, CA, USA,IEEE COMPUT. SOC, US, 15. September 1997 (1997-09-15), Seiten 164-181, XP010256321 ISBN: 0-8186-7913-1

## Beschreibung

Die vorliegende Erfindung betrifft eine Schaltungsanordnung zum Detektieren eines unerwünschten Angriffs auf eine integrierte Schaltung mit einer Signalleitung, die mit einem Taktsignal beaufschlagt ist sowie mit wenigstens einem Leitungspaar, das jeweils zur Codierung eines Bits dient, wobei die Signalleitung und das wenigstens eine Leitungspaar zwischen einem ersten und einem zweiten Schaltungsblock der integrierten Schaltung verschalten sind.

Viele Schaltungen, die zum Beispiel in Mikroprozessoren, Security Token oder anderen Datenverarbeitungseinheiten eingesetzt werden, benötigen eine vor physikalischen Angriffen und vor Abhören gesicherte Verarbeitung von Daten auf einem hohen Sicherheitsniveau. Ein derartiger Angriff ist durch Analyse der integrierten Schaltung mittels "Reverse Engineering" möglich. Mittels dieser Analyse ist es möglich, sowohl die Funktionsweise der integrierten Schaltung zu analysieren als auch die Funktionsweise zum Zwecke einer Manipulation eines Dateninhaltes oder des Funktionsablaufes zu beeinflussen.

In der Praxis existieren bereits verschiedene Verfahren, mit denen eine derartige Analyse zumindest erschwert werden kann.

Zum Beispiel ist es bekannt, die integrierte Schaltung mit einem sogenannten "Shield" abzudecken. Ein Shield besteht dabei aus wenigstens zwei über der integrierten Schaltung - in der Regel mäanderförmig - verlaufenden Leiterbahnen. Eine Unterbrechung oder ein Kurzschluß dieser Leiterbahnen wird durch eine Auswerteschaltung detektiert, die dann die integrierte Schaltung in einen sicheren Zustand verbringt. Dies könnte beispielsweise das Auslösen eines Resets oder das Löschen von Speicherinhalten sein.

Weiterhin sind Verfahren bekannt, mit dem die Entfernung eines aus Pressmasse bestehenden Kunststoffgehäuses detektiert werden kann. Dabei wird die sich ändernde Kapazität zwischen zwei Leiterzügen beim Entfernen der Kunststoffpressmasse detektiert. Zu diesem Zweck ist eine Mehrzahl an Sensoren in dem Kunststoffpressmassengehäuse vorgesehen.

Weiterhin gibt es Verfahren, die die Entfernung der Passivierungsschicht über die Chipoberfläche detektieren.

Um kryptoanalytische Angriffe abzuwehren, werden integrierte Schaltungen in sicherheitsrelevanten Einsatzgebieten oftmals in der als "Dual-Rail with Precharge" bekannten Schaltungstechnik realisiert. Ein Bit wird dabei mittels zweier komplementärer Leitungen codiert. In einer ersten Taktphase, der sogenannten "Precharge Phase" werden die beiden komplementären Leitungen vorgeladen (Logisch 1 oder High), wodurch vorher gespeicherte Informationen gelöscht werden. In der zweiten Taktphase, der sogenannten "Evaluation Phase" wird eine der beiden Leitungen entladen (Logisch 0 oder Low) und in der nächsten Taktflanke ausgewertet.

Dieses Verfahren ist aus WO 99/04334 bekannt.

All die oben genannten Detektionsverfahren dienen dazu, einen Zugriff auf die Leiterzüge der integrierten Schaltung zu verhindern. Sobald diese Hürden übersprungen sind, können die über die Leiterzüge der integrierten Schaltung gesendeten Daten analysiert oder manipuliert werden. Letzteres kann z.B. durch Aufprägen einer Spannung oder durch Durchtrennen von Leitungen geschehen.

Die Aufgabe der vorliegenden Erfindung besteht deshalb darin, eine Schaltungsanordnung sowie ein Verfahren zum Detektieren eines unerwünschten Angriffs auf eine integrierte Schaltung anzugeben, die einen verbesserten Schutz ermöglicht.

Diese Aufgabe wird mit den Merkmalen des Patentanspruches 1, der die Schaltungsanordnung wiedergibt, sowie mit den Merkmalen des Patentanspruches 4, in welchem das Verfahren wiedergegeben ist, gelöst. Vorteilhafte Ausgestaltungen ergeben sich aus den untergeordneten Ansprüchen.

Die integrierte Schaltung bedient sich dabei der oben genannten "Dual-Rail with Precharge"-Technologie, das heißt zur Codierung eines Bits wird ein Leitungspaar verwendet. Die integrierte Schaltung kann dabei eine Vielzahl an Leitungspaaren aufweisen. Erfindungsgemäß ist vorgesehen, daß eine Signalleitung, die mit einem Taktsignal beaufschlagt ist, und das wenigstens eine Leitungspaar mit einer Detektorschaltung verbunden sind, die in Abhängigkeit der Signale der Signalleitung und des wenigstens einen Leitungspaares die integrierte Schaltung in ihrem Funktionsablauf ändert.

In einer Variante ist jede Leitung des wenigstens einen Leitungspaares direkt mit der Detektorschaltung verbunden. Alternativ können die Leitungspaare bei einem Multiplexer mit der Detektorschaltung verbunden sein. Die Signalleitung, die mit einem Taktsignal beaufschlagt ist, ist in jeder der beiden Varianten mit der Detektorschaltung verbunden.

Die erfindungsgemäße Schaltungsanordnung macht sich dabei den Umstand zu Nutze, daß den gültigen Zuständen bei der "Dual-Rail with Precharge"-Technologie den gültigen logischen Zuständen fünf verbotene Zustände gegenüberstehen. Diese werden durch die Detektorschaltung ermittelt, wodurch im Bedarfsfall der Funktionsablauf der integrierten Schaltung geändert werden kann.

Die erfindungsgemäße Schaltungsanordnung ist vorteilhafterweise äußerst einfach aufgebaut, da sie zusätzlich lediglich eine Detektorschaltung benötigt, welche mit den Leitungspaaren und der Signalleitung, die mit einem Taktsignal beaufschlagt ist.

Die Funktionsweise der erfindungsgemäßen Schaltungsanordnung wird aus dem nachfolgend beschriebenen Verfahren deutlich.

Bei einem ersten Signalwert der Signalleitungen werden die zwei Leitungen eines Leitungspaares auf einen gleichen Signalpegel hin detektiert. Bei einem zweiten Signalwert der Signalleitung werden die zwei Leitungen eines Leitungspaares auf einen unterschiedlichen Signalpegel hin detektiert, wobei bei einer Abweichung von den erwarteten Ergebnissen die integrierte Schaltung in ihrem Funktionsablauf geändert wird.

Mit anderen Worten bedeutet dies, daß bei einem der fünf verbotenen Zustände, die nachfolgend näher erläutert werden, ein Funktionsablauf der integrierten Schaltung herbeigeführt wird. Das erfindungsgemäße Verfahren bedient sich dabei der Überwachung des Ladungszustandes (Signalpegel) der beiden Leitungen eines Leitungspaares, wobei die Überprüfung der verbotenen Zustände mittels einer Zustands- oder Gültigkeitstabelle dargestellt werden kann. Die schaltungstechnische Realisierung der Gültigkeitstabelle stellt eine Standardaufgabe dar und wird hier deshalb nicht näher erläutert.

Die Precharge-Phase kann prinzipiell wahlweise bei einem ersten Signalwert Logisch 0 oder Logisch 1 festgelegt werden.

Vorteilhafterweise ist der erste Signalwert der Signalleitung Logisch 0. In diesem Fall entspricht die Zustandstabelle dem üblichen Vorgehen bei der "Dual-Rail with Precharge"-Technologie.

Während an der Signalleitung der erste Signalwert anliegt, ist der Signalpegel der zwei Leitungen eines Leitungspaares in einer Ausgestaltung jeweils Logisch 0 oder jeweils Logisch 1. Durch einen dieser beiden Zustände wird somit ein gültiger "Precharge" festgelegt. Die jeweils drei anderen verbleibenden Zustände definieren somit die verbotenen Zustände.

Entsprechend ist der zweite Signalwert der Signalleitung Logisch 1 oder Logisch 0. Der zweite Signalwert ist somit grundsätzlich komplementär zu dem ersten Signalwert der Signalleitung.

Während der zweite Signalwert der Signalleitung anliegt, ist der Signalwert der ersten Leitung eines Leitungspaares Logisch 0 oder 1, während der Signalpegel der zweiten Leitung Logisch 1 oder 0, also komplementär, ist.

Ein verbotener Zustand liegt folglich dann vor, wenn während des zweiten Signalwertes der Signalleitung an beiden Leitungen eines Leitungspaares ein identischer Wert anliegt. Insgesamt ergeben sich somit fünf verbotene Zustände.

Das erfindungsgemäße Vorgehen wird anhand der nachfolgenden Figuren weiter erläutert. Es zeigen:
- Figur 1: ein erstes Ausführungsbeispiel der erfindungsgemäßen Schaltungsanordnung,
- Figur 2: ein zweites Ausführungsbeispiel der erfindungsgemäßen Schaltungsanordnung,
- Figur 3: einen beispielhaften Signalverlauf der Signalleitung sowie zweier Leitungspaare, und
- Figur 4 bis 7: vier Zustandstabellen.

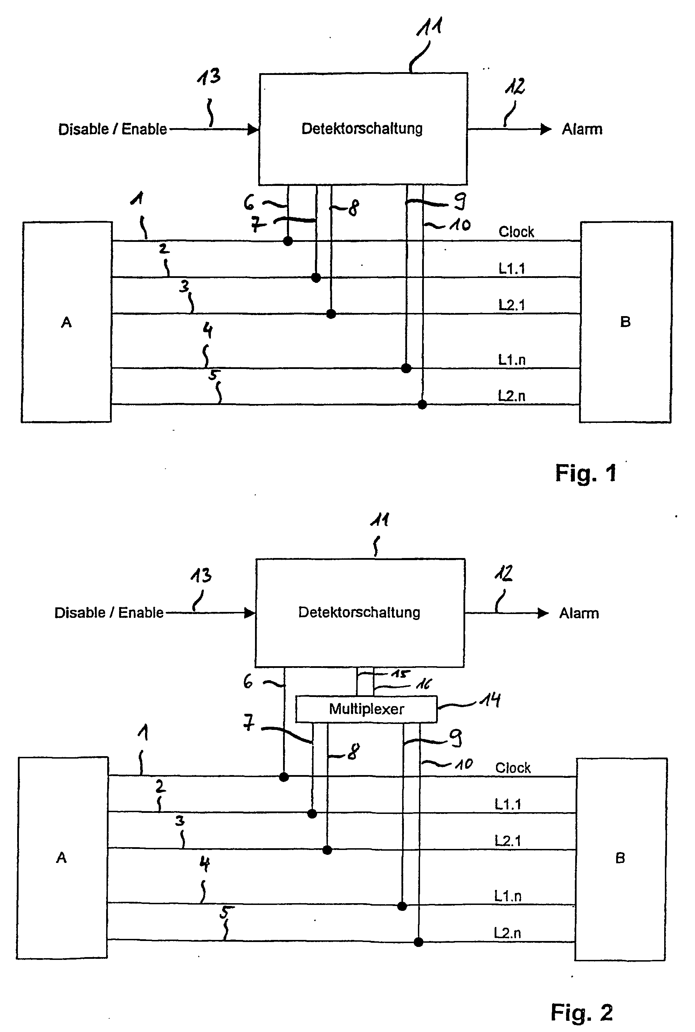

Figur 1 zeigt ein erstes Ausführungsbeispiel der erfindungsgemäßen Schaltungsanordnung zum Detektieren eines unerwünschten Angriffs auf eine integrierte Schaltung. Die integrierte Schaltung wird in der vorliegenden Figur 1 beispielhaft durch die Schaltungsblöcke A, B dargestellt, zwischen denen sich Leiterzüge 1 bis 5 befinden. Der Leiterzug 1 stellt dabei die Signalleitung "Clock" dar, die mit einem Taktsignal beaufschlagt ist. Weiterhin sind beispielhaft zwei Leitungspaare L1.1, L2.1 sowie L1.n, L2.n dargestellt. Zwischen den Schaltungsblöcken A, B können somit im vorliegenden Beispiel zwei Bit übertragen werden. Prinzipiell können natürlich beliebig viele Leitungspaare zwischen den Schaltungsblöcken A und B verschalten sein.

Erfindungsgemäß ist zur Überwachung der Leiterzüge eine Detektorschaltung 11 vorgesehen. Jede der Signalleitungen 1 bis 5, die zwischen den Schaltungsblöcken A, B verschalten ist, ist mit der Detektorschaltung 11 verbunden. Dies wird durch die Leiterzüge 6 bis 10 dargestellt. Im Falle eines verbotenen Zustandes kann die Detektorschaltung 11 über eine Leitung 12 einen Alarm auslösen, wodurch die integrierte Schaltung beispielsweise neu gestartet werden kann oder sicherheitsrelevante Daten gelöscht werden können.

Weiterhin ist es denkbar, die Detektorschaltung 11 selektiv mittels einer Signalleitung 13 zu aktivieren oder zu deaktivieren.

In dem ersten Ausführungsbeispiel nach Figur 1 ist jede der Signalleitungen 1 bis 5 direkt mit der Detektorschaltung 11 verbunden. In dem Ausführungsbeispiel nach Figur 2 ist lediglich die Signalleitung 1, an der das Taktsignal anliegt, über die Signalleitung 6 direkt mit der Detektorschaltung 11 verbunden. Die Leitungspaare L1.1, L2.1 sowie L1.n, L2.n sind hingegen über einen Multiplexer 14 mit der Detektorschaltung 11 verbunden.

Während in der Figur 1 eine Überprüfung aller Leitungspaare gleichzeitig erfolgen kann, werden die Leitungspaare in der Figur 2 nacheinander auf einen verbotenen Zustand hin überprüft. Da die Funktionsweise eines Multiplexers aus dem Stand der Technik hinlänglich bekannt ist, wird an dieser Stelle auf eine ausführliche Beschreibung der Funktionsweise verzichtet.

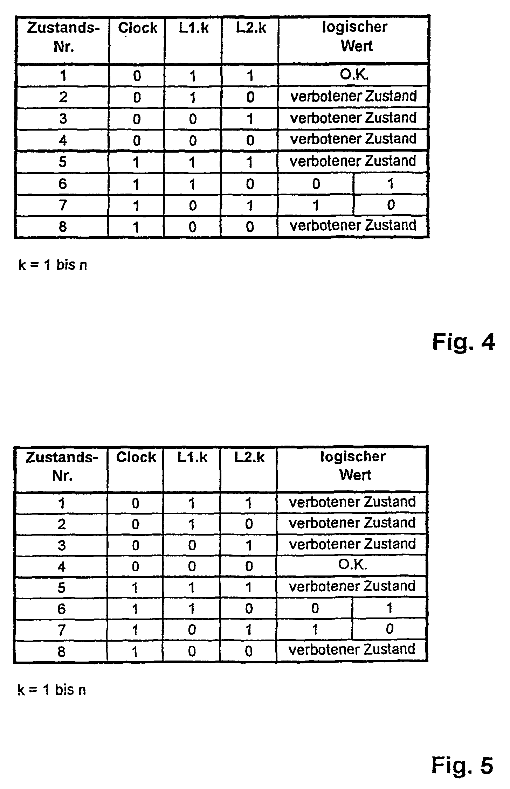

Anhand der Zustandstabellen in den Figuren 4 bis 7 kann die Funktionsweise der erfindungsgemäßen Schaltungsanordnung besser verstanden werden. In der ersten Spalte ist die Nummer eines möglichen Zustands gekennzeichnet. Die Spalten 2 bis 4 bezeichnen mögliche Zustände der Signalleitung Clock sowie der zwei Leitungen eines Leitungspaares, die im vorliegenden Fall mit L1.k, L2.k gekennzeichnet sind. Der Platzhalter k steht dabei stellvertretend für Leitungspaare 1 bis n. In der letzten Spalte ist der logische Wert, der von der Detektorschaltung 11 überwacht wird, angegeben.

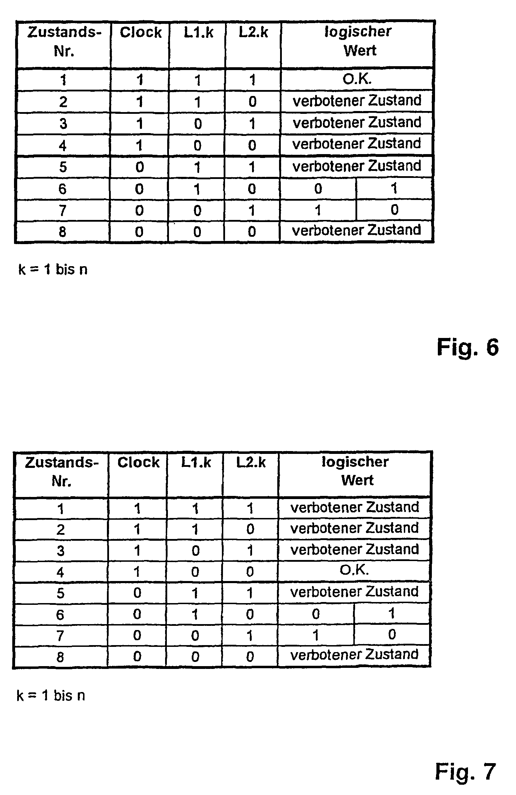

während der ersten vier Zustände (Zustandsnummer 1 bis 4) befindet sich die Signalleitung Clock in der sogenannten Precharge-Phase. Während dieser Phase müssen die Ladungszustände der zwei Leitungen eines Leitungspaares L1.k, L2.k identische Werte aufweisen. In den Figuren 4 und 6 ist dies der Fall, wenn L1.k und L2.k den Wert Logisch 1 aufweisen, während dies in den Figuren 5 und 7 bei einem Wert von Logisch 0 der Fall ist.

In der sogenannten "Evaluation Phase" (Zustandsnummer 5 bis 8) dürfen die Leitungen L1.k, L2.k keinen identischen Ladungszustand aufweisen. In diesem Fall liegt ein Fehler oder ein Angriff vor. Wahlweise ist es möglich, der Zustandsnummer 6 einen logischen Wert von 0 oder 1 zuzuweisen. Dementsprechend beträgt der logische Wert bei der Zustandsnummer 7 1 oder 0, das heißt er ist komplementär zu dem logischen Wert der Zustandsnummer 6.

Die Verwendung der in den Figuren 4 und 5 gezeigten Zustandstabellen für das erfindungsgemäße Detektionsverfahren ist vorteilhaft, da die Precharge Phase bei einem logischen Wert 0 der Signalleitung Clock durchgeführt wird. Alternativ ist es natürlich auch denkbar, die Precharge Phase bei einem Wert Logisch 1 und die Evaluation Phase bei einem Wert Logisch 0 durchzuführen. Dies ist in den Zustandstabellen 6 und 7 gezeigt.

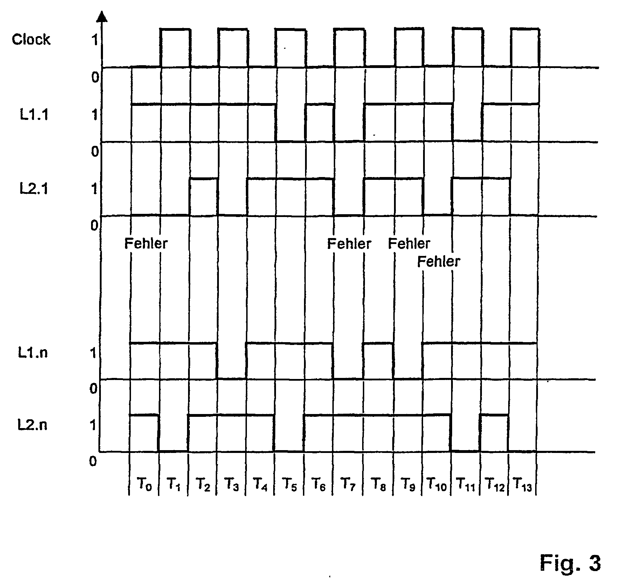

In Figur 3 ist ein beispielhafter Signalverlauf der Signalleitung "Clock" sowie zweier Leitungspaare L1.1, L2.1 sowie L1.n, L2.n dargestellt. Für die Überprüfung, ob ein verbotener Zustand, zum Beispiel ein Fehler oder ein Angriff vorliegt, müssen grundsätzlich die Signale der Signalleitung sowie die Signale eines Leitungspaares miteinander verglichen werden. Der in der Figur 3 gezeigte Signalverlauf wird nach der Zustandstabelle gemäß Figur 4 ausgewertet. Somit liegt bei dem ersten Leitungspaar bereits während des ersten Signalwertes der Signalleitung "Clock" (Taktphase T₀)ein Fehler vor, da die zweite Leitung L2.1 während der "Precharge Phase" keinen identischen Signalwert annimmt. Während der Taktphasen T₇ beziehungsweise T₉ liegt während der "Evaluation Phase" jeweils ein Fehler vor, da dort die Signalzustände der beiden Leitungen des Leitungspaares 1 einen identischen Ladungszustand aufweisen, was gemäß der Zustandstabelle nach Figur 4 verboten ist. Ein weiterer Fehler findet sich während der Taktphase T₁₀.

Der Signalverlauf des n-ten Leitungspaares hingegen ist, wie ein Vergleich mit der Zustandstabelle gemäß Figur 4 zeigt, in Ordnung.

### Bezugszeichenliste

- 1...5: Leiterzug
- 6...10: Leiterzug
- 11: Detektorschaltung
- 12: Signalleitung
- 13: Signalleitung
- 14: Multiplexer
- 15: Leiterzug
- 16: Leiterzug
- A,B: Schaltungsblock

## Patentansprüche

1. Schaltungsanordnung zum Detektieren eines unerwünschten Angriffs auf eine integrierte Schaltung (A, B) mit
- einer Signalleitung (1), die mit einem Taktsignal beaufschlagt ist, so daß in einer ersten Taktphase ein erster Signalwert anliegt und in einer zweiten Taktphase ein zweiter Signalwert anliegt,
- wenigstens einem Leitungspaar (2, 3; 4, 5), das jeweils zur Codierung eines Bits dient, wobei in einer ersten Taktphase die beiden Leitungen einen gleichen Signalpegel aufweisen und in der zweiten Taktphase die beiden Leitungen unterschiedliche Signalpegel aufweisen und
wobei die Signalleitung (1) und das wenigstens eine Leitungspaar (2, 3; 4, 5) zwischen einem ersten und zweiten Schaltungsblock (A, B) der integrierten Schaltung verschaltet sind,
**dadurch gekennzeichnet, daß** die Signalleitung (1) und das wenigstens eine Leitungspaar (2, 3; 4, 5) mit einer Detektorschaltung (11) verbunden sind, die in Abhängigkeit der Signale der Signalleitung (1) und des wenigstens einen Leitungspaares (2, 3; 4, 5) die integrierte Schaltung in ihrem Funktionsablauf ändert, wenn beim ersten Signalwert der Signalleitung (1) die beiden Leitungen nicht den gleichen Signalpegel haben oder wenn beim zweiten Signalwert der Signalleitung (1) die beiden Leitungen einen identischen Signalpegel haben, und wobei die Änderung des Funktionablaufs zur Auslösung eines Alarms führt.

2. Schaltungsanordnung nach Anspruch 1,
wobei jede Leitung des wenigstens einen Leitungspaares (2, 3; 4, 5) direkt mit der Detektorschaltung (11) verbunden ist.

3. Schaltungsanordnung nach Anspruch 1,
wobei die Leitungspaare (2, 3; 4, 5) über einen Multiplexer mit der Detektorschaltung (11) verbunden sind.

4. Verfahren zum Detektieren eines unerwünschten Angriffs auf eine integrierte Schaltung, die zur Übertragung je eines Bits zwischen einem ersten und einem zweiten Schaltungsblock ein Leitungspaar (2, 3; 4, 5) aufweist und die eine Signalleitung (1), die mit einem Taktsignal beaufschlagt ist, aufweist, bei dem
a) bei einem ersten Signalwert der Signalleitung (1) die zwei Leitungen eines Leitungspaares (2, 3; 4, 5) auf einen gleichen Signalpegel hin detektiert werden,
b) bei einem zweiten Signalwert der Signalleitung (1) die zwei Leitungen eines Leitungspaares (2, 3; 4, 5) auf einen unterschiedlichen Signalpegel hin detektiert werden,
wobei bei einer Abweichung von den in den Schritten a) und/oder b) erwarteten Ergebnissen die integrierte Schaltung in ihrem Funktionsablauf dermaßen geändert wird, daß ein Alarm ausgelöst wird.

5. Verfahren nach Anspruch 4,
wobei der erste Signalwert der Signalleitung (1) Logisch 0 oder Logisch 1 ist.

6. Verfahren nach Anspruch 5,
wobei der Signalpegel der zwei Leitungen eines Leitungspaares (2, 3; 4, 5) jeweils Logisch 0 oder jeweils Logisch 1 ist.

7. Verfahren nach einem der Ansprüche 4 bis 6,
wobei der zweite Signalwert der Signalleitung (1) Logisch 1 oder Logisch 0 ist.

8. Verfahren nach Anspruch 7,
wobei der Signalpegel der ersten Leitung eines Leitungspaares (2, 3; 4, 5) Logisch 0 oder 1 ist, während der Signalpegel der zweiten Leitung Logisch 1 oder 0 ist.

## Claims

1. Circuit arrangement for detecting an unwanted attack on an integrated circuit (A, B) having
- a signal line (1) to which a clock signal is applied, so that a first signal value is applied in a first clock phase and a second signal value is applied in a second clock phase.
- at least one line pair (2, 3; 4, 5) which is respectively used to code a bit, the two lines having an identical signal level in the first clock phase and the two lines having a different signal level in the second clock phase, and
where the signal line (1) and the at least one line pair (2, 3; 4, 5) are connected between a first and a second circuit block (A, B) in the integrated circuit,
**characterized in that**
the signal line (1) and the at least one line pair (2, 3; 4, 5) are connected to a detector circuit (11) which changes the operating sequence in the integrated circuit on the basis of the signals of the signal line (1) and at least one line pair (2, 3; 4, 5) if the two lines do not have the identical signal level at the first signal value of the signal line (1) or if the two lines have an identical signal level at the second signal value of the signal line (1) and in which this changing of the operating sequence triggers an alarm.

2. Circuit arrangement according to Claim 1,
in which each line in the at least one line pair (2, 3; 4, 5) is connected directly to the detector circuit (11).

3. Circuit arrangement according to Claim 1,
in which the line pairs (2, 3; 4, 5) are connected to the detector circuit (11) by means of a multiplexer.

4. Method for detecting an unwanted attack on an integrated circuit which has a line pair (2, 3; 4, 5) for the purpose of transmitting a respective bit between a first and a second circuit block and which has a signal line (1) to which a clock signal is applied, in which
a) a first signal value on the signal line (1) involves the two lines in a line pair (2, 3; 4, 5) being detected for an identical signal level,
b) a second signal value on the signal line (1) involves the two lines in a line pair (2, 3; 4, 5) being detected for a different signal level,
with any discrepancy from the results expected in steps a) and/or b) involving the operating sequence in the integrated circuit being changed in a way that triggers an alarm.

5. Method according to Claim 4,
in which the first signal value on the signal line (1) is Logic 0 or Logic 1.

6. Method according to Claim 5,
in which the signal level on the two lines in a line pair (2, 3; 4, 5) is respectively Logic 0 or respectively Logic 1.

7. Method according to one of Claims 4 to 6,
in which the second signal value on the signal line (1) is Logic 1 or Logic 0.

8. Method according to Claim 7,
in which the signal level on the first line in a line pair (2, 3; 4, 5) is Logic 0 or 1, while the signal level on the second line is Logic 1 or 0.

## Revendications

1. Montage de détection d'une attaque indésirable d'un circuit (A, B) intégré comprenant
- une ligne (1) de signal qui est alimentée en un signal d'horloge, ainsi que dans la première phase d'horloge une première valeur de signal se trouve sur la ligne de signal et dans la deuxième phase d'horloge une deuxième valeur de signal se trouve sur la ligne de signal,
- au moins une paire (2, 3; 4, 5) de lignes, qui sert respectivement au codage d'un bit, les deux lignes ayant le même niveau de signal pendant la première phase d'horloge et un niveau de signal différent pendant la deuxième phase d'horloge, et
la ligne (1) de signal et la au moins une paire (2, 3; 4, 5) de lignes étant montées entre un premier et un deuxième blocs (A, B) du circuit intégré, **caractérisé en ce que**
la ligne (1) de signal et la au moins une paire (2, 3; 4, 5) de ligne sont reliées à un circuit (11) formant déctecteur qui, modifie le fonctionnement du circuit intégré en fonction des signaux de la ligne de signal(1) et de la au moins une paire de lignes (2, 3; 4, 5), si pour une première valeur de signal de la ligne de signal (1) les deux lignes n'ont pas un niveau de signal identique ou si pour une deuxième valeur de signal de la ligne de signal (1) les deux lignes ont un niveau de signal identique, cette modification du fonctionnement déclenchant une alarme.

2. Montage suivant la revendication 1,
dans lequel chaque ligne de la au moins une paire (2, 3; 4, 5) de lignes est reliée directement au circuit (11) formant déctecteur.

3. Montage suivant la revendication 1,
dans lequel les paires (2, 3; 4, 5) de lignes sont reliées au circuit (11) formant déctecteur par un multiplexeur.

4. Procédé de détection d'une attaque indésirable d'un circuit intégré qui, pour la transmission de respectivement un bit entre un premier et un deuxième blocs de circuit, à une paire (2, 3; 4, 5) de lignes et qui a une ligne (1) de signal qui est alimentée en un signal d'horloge, dans lequel
a) pour une première valeur de signal de la ligne (1) de signal, on détecte un même niveau de signal sur les deux lignes d'un paire (2, 3; 4, 5) de lignes,
b) pur une deuxième valeur de signal de la ligne (1) de signal, on détecte un niveau différent de signal sur les deux lignes d'une paire (2, 3; 4, 5) de lignes et, s'il y a un écart entre les résultats auxquels on s'attend aux stades a) et/ou b), on modifie le fonctionnement du circuit intégré d'une manière qui déclenche une alarme.

5. Procédé suivant la revendication 4, dans lequel la première valeur de signal de la ligne (1) de signal est un 0 logique ou un 1 logique.

6. Procédé suivant la revendication 5, dans lequel le niveau de signal des deux lignes d'une paire (2, 3; 4, 5) de lignes est respectivement un 0 logique ou respectivement un 1 logique.

7. Procédé suivant la revendications 4 à 6, dans lequel la deuxième valeur de signal de la ligne (1) de signal est un 1 logique ou un 0 logique.

8. Procédé suivant la revendication 7, dans lequel le niveau de signal de la première ligne d'une paire (2, 3; 4, 5) de lignes est un 0 logique ou un 1 logique, tandis que le niveau de signal de la deuxième ligne est un 1 logique ou un 0 logique.
